# EUROPEAN PATENT SPECIFICATION

(11) **EP 2 746 838 B1**
(45) Date of publication and mention of the grant of the patent: **04.02.2026**
(21) Application number: 13198496.5
(22) Date of filing: 19.12.2013
(51) Int. Cl.: G02C 13/00

(54) **Method and device for determining user preferred dimensions of a spectacle frame**
Verfahren und Vorrichtung zur Bestimmung benutzerbevorzugter Abmaße einer Brillenfassung
Procédé et dispositif permettant de déterminer les dimensions préférées d'un utilisateur d'une monture de lunettes

(30) Priority: 19.12.2012 NL 2010009
(43) Date of publication of application: 25.06.2014
(73) Proprietor: Sfered Intelligence B.V., 1079 HR Amsterdam (NL)
(72) Inventor: Tutuarima, Peter Emanuel, 1079 HR Amsterdam (NL); De Graaf, Reinout Sybren, 1079 HR Amsterdam (NL)
(74) Representative: V.O.

(56) References cited:
- FR-A1- 2 885 231
- US-A1- 2003 123 026
- US-A1- 2005 162 419
- PAULO BARTOLO ET AL.: "Virtual and Rapid Manufacturing", 16 October 2007, TAYLOR&FRANCIS, ISBN: 978-0-415-41602-3, article STEINAR KILLI: "Custom design, more than custom to fit", pages: 777 - 783, XP002704062
- IONUT GABRIEL GHIONEA ET AL: "Parametric Modeling of Surfaces Using CATIA v5 Environment", APPLIED MECHANICS AND MATERIALS, vol. 760, 1 May 2015 (2015-05-01), pages 93 - 98, XP055737143, DOI: 10.4028/www.scientific.net/AMM.760.93
- DASSAULT SYST�MES: "Dassault Syst�mes Products Lines Releases Support Life Cycle Dates", 4 March 2020 (2020-03-04), pages 1 - 50, XP055747663, Retrieved from the Internet <URL:https://support.dte.co.uk/download/DS/DS_LifeCycleInformation.pdf> [retrieved on 20201106]
- DASSAULT SYSTEMS: "Instructor Notes: Introduction to the Mathematical Concepts of CATIA V5", 1 January 2009 (2009-01-01), pages 1 - 18, XP055747655, Retrieved from the Internet <URL:http://yvonet.florent.free.fr/SERVEUR/COURS%20CATIA/CATIA%20Shape%20Design%20and%20Styling/MTH_F/Teacher/EDU_CAT_EN_MTH_FI_V5R19_toprint.pdf> [retrieved on 20201106]
- SHAM DICKSON: "CATIA V5R19 Surface modeling - Glasses", 1 June 2010 (2010-06-01), pages 1 - 70, XP055747699, Retrieved from the Internet <URL:https://vdocument.in/34639016-free-catia-training-tutorial-6-glasses.html> [retrieved on 20201106]
- CADCIM TECHNOLOGIES: "Working with Wireframe and Surface Design Workbench Learning Objectives 9-2 CATIA for Designers (Evaluation Chapter F007/004) NEED OF SURFACE MODELING", 1 January 2004 (2004-01-01), XP055747067, Retrieved from the Internet <URL:http://catiadoc.free.fr/pdf/EN-Catia_v5r13_Designer_Guide_Chapter9-Working_with_Wireframe_and_Surface_Design_Workbench.pdf> [retrieved on 20201104]
- CATIAJIM ET AL: "Catia V5 -Parameters and Formulas Tutorial Table of Contents I. Tutorial Overview", 9 May 2006 (2006-05-09), pages 1 - 25, XP055747733, Retrieved from the Internet <URL:https://torrecillacatia.com/forum/sites/default/files/foro/archivo/Catia%20v5%20Parameters%20And%20Formulas%20Tutorial(1)_1.pdf> [retrieved on 20201106]
- MEHDI FRANCISCO TARKIAN JAVIER ZALDIVAR TESSIER ET AL: "Aircraft Parametric 3D Modelling and Panel Code of Analysis for Conceptual Design", 28 February 2007 (2007-02-28), pages 1 - 123, XP055747725, Retrieved from the Internet <URL:https://www.diva-portal.org/smash/get/diva2:17328/FULLTEXT01.pdf> [retrieved on 20201106]

## Description

### TECHNICAL FIELD

The various aspects relate to providing a design of a spectacle frame specifically adapted to a head of specific person.

### BACKGROUND

Spectacle frames are adapted to heads of wearers by bending various portions of the frames by means of pliers. By iteration, usually the correct shape is found by the optician. This method works not too bad with metal and certain plastic frames. However, with odd-shaped heads and certain materials, the current method has its limits.

US 2003/0123026 A1 discloses A spectacles fitting system including a wide-view imaging system operative to provide a wide-view of a client's face, a 3D image processor operative to generate first 3D information describing the client's physical features, a virtual try-on unit operative to receive the digital 3D representation of the client's face and a digital 3D representation of a spectacle frame, to virtually mount the spectacle frame onto the client's face and to generate second 3D information describing frame/facial fit, and a lens fitter operative to receive the first 3D information and the second 3D information and to generate therefrom at least one parameter for face-and-frame customized manufacture and cutting of the lens.

Steinar Killi: "Custom design, more than custom to fit" In: Paulo Bartolo et al.: "Virtual and Rapid Manufacturing" 16 October 2007 (2007-10-16), Taylor&Francis, discloses a design methodology required to design custom fitted products with malleable aesthetic features whose boundaries are set by a designer. To some extent a design template is developed and tested. A case study with sunglasses is used as an example.

FR 2 885 231 discloses a method involving acquiring an image of the face of a consumer, and analyzing the image in order to measure characteristics of the morphology of the face of the consumer. A spectacle frame adapted to the morphology of the consumer is selected by interrogation of a spectacle frame characteristic indexing database including four dimensional characteristics of each spectacle frame. An image of spectacle frame adapted to the consumer is incorporated to an image of the consumer. Independent claims are also included for the following: (1) an interactive terminal (2) a device for analyzing spectacle frames permitting to inform a database on the dimensional characteristics of the frames (3) an assembly including spectacle frames and a computing unit in which data concerning the spectacle frames are stored.

US2005162419A1 discloses A 3D virtual simulation system and method that provide decision-making information for selection and purchase of eyeglasses. The system is comprised of four major units: 3D graphic simulation unit, contents delivery unit intelligent, Customer Relation Management (CRM) unit and back-office unit. 3D graphic simulation unit generates 3D face models of a user face and eyeglasses, and fit those objects automatically on networked platforms at real-time. The 3D face model is created from photo images of the face with options to select hair models. The 3D eyeglasses model is generated by a systematic reverse engineering process with specially designed measuring device. Graphic simulation unit transacts with intelligent CRM unit, so that user behavior is tracked down for push-marketing activity. Contents are delivered in a form of service-on-demand and ASP (Application Service Provider). This system enables precise virtual simulation of wearing eyeglasses with real dimensions of face and eyeglasses models and provides data and tools for custom-made production of eyeglasses assisted by expert knowledge base.

### SUMMARY

There is a preference to provide a better way of providing spectacle frames adapted to the intended wearer.

A first aspect provides a method of determining user preferred dimensions of a spectacle frame for providing a bespoke spectacle frame design. The method comprises receiving locations of reference points on or around a head of an intended wearer of the spectacle frame as biometric data related to dimensions of a head of the user and receiving pre-determined design data on a spectacle frame and receiving pre-determined design data on a spectacle frame comprising a mathematical system describing the spectacle frame, the system comprising a first mathematical model describing a main curve defining a shape of an element of the spectacle, the mathematical model comprising at least one variable that can be adapted based on the biometrics data and/or user preference data, wherein the pre-determined design data further comprises a second mathematical model describing a first support curve and a third mathematical model describing a second support curve, the main curve, the first support curve and the second support curve defining a volume of the spectacle frame, wherein the second mathematical model and the third mathematical model are dependent on the first mathematical model, and wherein the mathematical models each comprise splines. The biometrics data are applied to the pre-determined design data by applying the locations of the reference points as control points for the splines, yielding a user specific spectacle frame design. Subsequently, the user specific frame design is provided to the user and user preference data related to the user specific frame design is received. The user preference data is applied to the user specific design, yielding the bespoke spectacle frame design defined by bespoke spectacle frame design data; and the bespoke spectacle frame design is provided to the user.

This allows a tailor-made spectacle frame to be designed for the user, based on a pre-determined basic design. There is no need to design a completely new spectacle frame; a pre-determined design of a spectacle frame is used as a starting point and biometric data of an intended wearer is applied to the design to provide a spectacle design fitting the intended wearer well.

With a mathematical model, the pre-determined design data can be stored and handled in an efficient way and also adapted in an efficient way by means of the biometrics data and/or the user preference data.

In an embodiment of the first aspect, the pre-determined design data comprises a first pre-determined spectacle frame biometric value defining a first spectacle frame dimension of a first element of the spectacle frame, the biometric data comprises a first biometric value related to the first spectacle frame dimension. Furthermore, applying the biometrics data to the pre-determined design data comprises adapting the first pre-determined spectacle frame biometric value to adapt the spectacle frame to the first biometric value.

This allows the pre-determined design data to be adapted in a convenient way to provide user specific spectacle frame design data.

In another embodiment of the first aspect, the pre-determined design data comprises a first pre-determined spectacle frame preference value defining a second spectacle frame dimension of a second element of the spectacle frame; the user preference data comprises a first preference value related to the second spectacle frame dimension; and applying the user preference data to the user specific design comprises adapting the first pre-determined spectacle frame preference value to adapt the user specific design to the first user preference value.

This allows the pre-determined design data to be adapted in a convenient way to provide bespoke spectacle frame design data.

In a further embodiment of the first aspect, wherein the pre-determined design data comprises a data range indicating a maximum value and a minimum value of the spectacle frame biometric value defining a first spectacle frame dimension, the further embodiment comprises setting the first pre-determined spectacle frame biometric value to the minimum value if the first pre-determined spectacle frame biometric value would be lower than the minimum value to adapt the spectacle frame to the first biometric value; and setting the first pre-determined spectacle frame biometric value to the maximum value if the first pre-determined spectacle frame biometric value would be higher than the maximum value to adapt the spectacle frame to the first biometric value.

Certain adaptations of the pre-defined spectacle frame design data may result in a malformed design. The malformation may be considered from an esthetical point of view, as well as from a functional or ergonomic point of view. By providing limits, such malformation is prevented.

A second aspect provides a device for determining user preferred dimensions of a spectacle frame for providing a bespoke spectacle frame design. The device comprises a data input module arranged to receive locations of reference points on or around a head of an intended wearer of the spectacle frame as biometric data related to dimensions of a head of the user; receive pre-determined design data on a spectacle frame comprising a mathematical system describing the spectacle frame, the system comprising a first mathematical model describing a main curve defining a shape of an element of the spectacle, the mathematical model comprising at least one variable that can be adapted based on the biometrics data and/or user preference data, wherein the pre-determined design data further comprises a second mathematical model describing a first support curve and a third mathematical model describing a second support curve, the main curve, the first support curve and the second support curve defining a volume of the spectacle frame, wherein the second mathematical model and the third mathematical model are dependent on the first mathematical model, and wherein the mathematical models each comprise splines, and receiving user preference data related to the user specific frame design. The device further comprises a processing unit arranged to apply the biometrics data to the pre-determined design data by applying the locations of the reference points as control points for the splines, yielding a user specific spectacle frame design; and to apply the user preference data to the user specific design, yielding the bespoke spectacle frame design defined by bespoke spectacle frame design data.

A third aspect provides a computer programme product comprising code executable by a computer, enabling the computer to execute the method according to the first aspect.

### BRIEF DESCRIPTION OF THE DRAWINGS

The various aspects and embodiments thereof will now be discussed in conjunction with Figures. In the Figures,
Figure 1: shows a computer with peripherals;
Figure 2: shows various views of a head with reference points;
Figure 3: shows various views of the head with a spectacle frame;
Figure 4: shows a flowchart depicting a procedure;
Figure 5 A: shows a rights side of a head with reference points;
Figure 5 B: shows a rights side of a head with a main spline for defining a right arm of a spectacle frame;
Figure 5 C: shows a rights side of a head with a main spline for defining a right arm of a spectacle frame and indications on how reference points may act as control points affecting curvature of the main spline;
Figure 5 D: shows a rights side of a head with a spectacle frame resulting out of adapting the main spline and rendering the main spline and auxiliary splines to a volume defining the right arm of the spectacle frame;
Figure 6 A: shows a right arm of a spectacle frame;
Figure 6 B: shows a cross-section of the right arm of the spectacle frame; and
Figure 6 C: shows another cross-section of the right arm of the spectacle frame.

### DETAILED DESCRIPTION

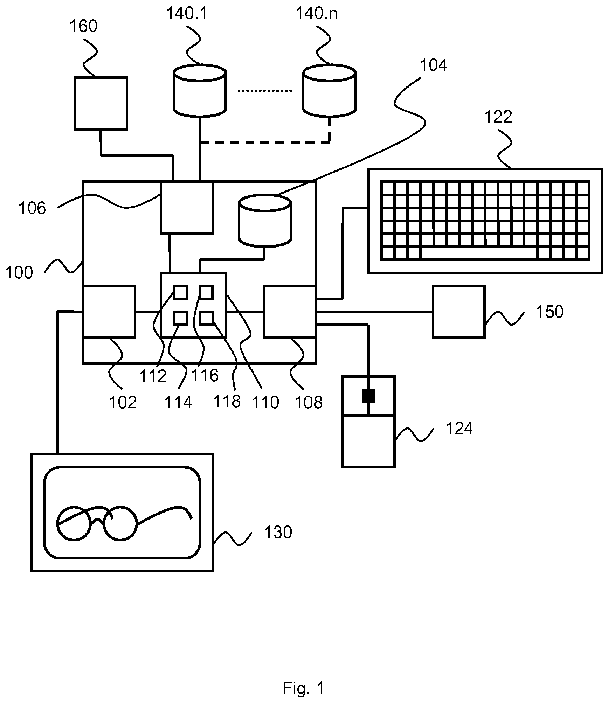

Figure 1 shows a computer system comprising a computer 100. The computer 100 comprises a display communication module 102, a computer storage module 104, a network communication module 106, a data input module 108 and a processing unit 110. The processing unit 110 comprises multiple sub-units that will be discussed in further detail below. The computer 100 is arranged for providing design data for a bespoke spectacle frame and or the dimensions of such frame in particular. A process for doing so will be discussed in further detail below. The computer storage module 104 has a computer programme stored on it for programming the computer 100 and the processing unit 110 in particular for executing the process and various embodiments and variations thereof.

The computer 100 is operatively connected to a keyboard 122, a mouse 124 and a biometric scan unit 150 via the data input module 108. The computer 100 is operatively connected to a display 130 via the display communication module 102. The display 130 may be a touch screen for receiving user input for controlling the computer 100. The computer 100 is operatively connected to a multitude of storage modules 140.n and a 3D printer via the network communication module 106.

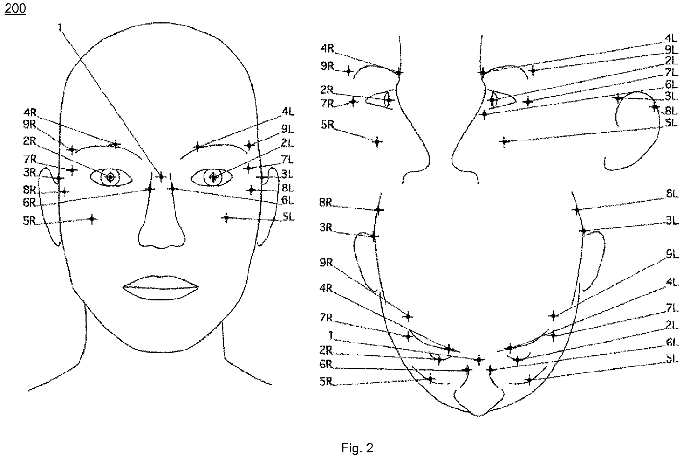

Figure 2 shows a front view of a head 200, a right view of the head 200, a left view of the head 200 and a top view of the head 200. In the various views of the head, reference points are indicated that may be relevant for determining dimensions of a spectacle frame. Reference point 1 is the Facial Meridian Reference Point. This is a single reference point. The other reference points are provided in pairs and have a left and right part. This is indicated by the "L" and "R" suffix for each reference number. Reference point 2 is the centre of the pupil, reference point 3 is the Tangent Temple, reference point 4 is the Apex forehead, reference point 5 is Apex Cheekbone, reference point 6 is the Tangent nose, reference point 7 is the Edge Orbita, reference point 8 is the Tangent Pars Petrosa and reference point 9 is the Edge Forehead. These reference points indicate extremities of the head 200 around the front half of the head 200.

These extremities are relevant for determining dimensions of a spectacle frame, as a spectacle frame should not interfere with the extremities. On the other hand, in certain use case, like spectacles to be worn during sports, it is also preferred to have the spectacle frame as closely to the head 200 as possible.

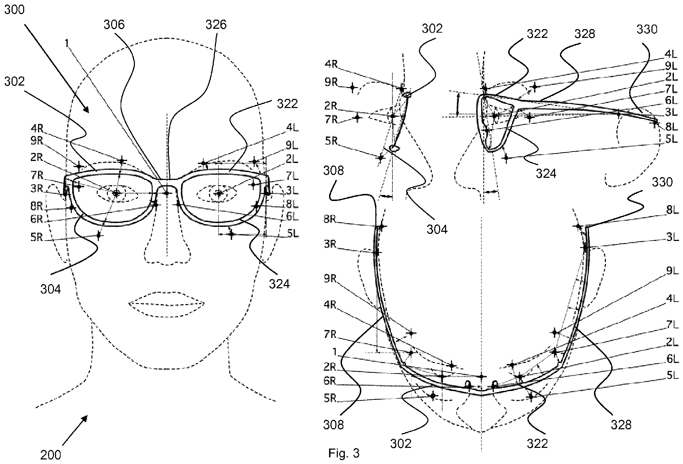

Figure 3 shows a spectacle frame 300 provided on the head 200. The spectacle frame 300 comprises on the right side a right upper rim 302, a right lower rim 304, a right bridge 306, a right arm 308 and a right arm bend 310. On the left side, the spectacle frame 300 comprises a left upper rim 322, a left lower rim 304, a left bridge 326, a left arm 328 and a left arm bend 330. Optionally, the spectacle frame 300 does not comprise the right lower rim 304 and the left lower rim 304.

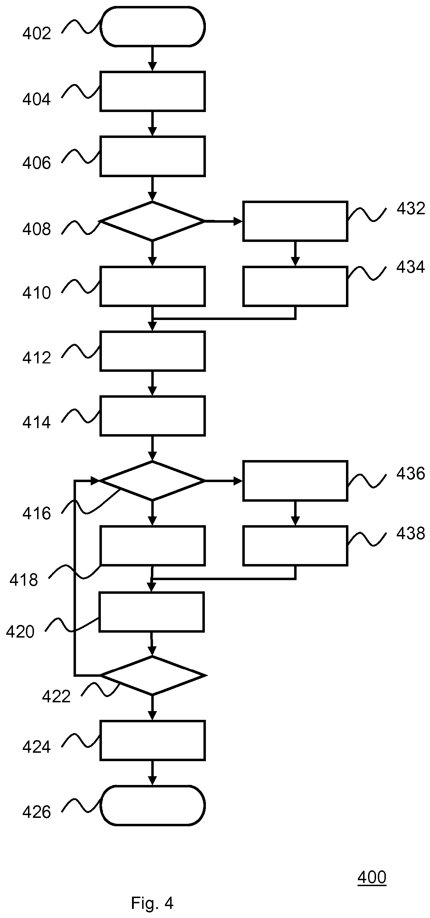

Figure 4 shows a flowchart 400 depicting a procedure for providing a bespoke spectacle frame. With this procedure, dimensions of a pre-defined spectacle frame design are automatically adapted to the head 200 and the reference points indicated before in particular. The table below briefly indicates the steps provided in the flowchart 400. These steps will be discussed in further detail below.
- 402: start process
- 404: receive biometric data
- 406: receive design data
- 408: biometric data within spec of design?
- 410: apply biometric data to design data
- 412: show user user specific design to user
- 414: receive user preference data
- 416: user preference data within spec of user specific design?
- 418: apply preference data to user specific design
- 420: show bespoke design to user
- 422: further user preference data received?
- 424: send bespoke spectacle design to printer
- 426: end process
- 432: apply maximum or minimum value
- 434: issue warning or error
- 436: apply maximum or minimum value
- 438: issue warning or error

The process starts in a starting point 402. Subsequently, biometric data is received in step 404. In one embodiment, locations of the reference points on the head 200 of an intended wearer of the spectacle frame are obtained as biometric data. The reference points may be provided in absolute coordinates with an external zero reference point, as positions relative to one another, or as positions relative to one reference point like the tangent nose. Alternatively, the full shape of the head 200 is acquired. The shape thus obtained may be further processed to provide a more abstract model of the head 200 by means of polygons. Methods for acquiring this data are commonly available. Such methods usually use optical measurement methods, reducing inconvenience to the measured person to a minimum as compared to the use of measurement tape. The scanning of the head 200 to obtain data on the reference points or the full contours of the head 200 is performed by means of the biometric scan unit 150. The data thus obtained is provided to the processing unit 110 via the data input module 108 for storage in the storage module 104.

In step 406, spectacle design data is received. The spectacle design data describes a shape of a spectacle frame, like the spectacle frame 300 as depicted by Figure 3. The design of the spectacle frame 300 may be described as a mathematical model and splines in particular. Such splines may be provided as curves, surfaces or a combination thereof. Alternatively, the design of the spectacle frame 300 is described by means of polygons, coordinates providing dots to be connected by lines or surfaces, other mathematical expressions or a combination thereof. The data describing the design of the spectacle frame 300 may be modified by altering certain variables in the mathematical models provided. Such modification may be done to adapt the design of the spectacle frame 300 to the head 200 of the user. This will be discussed below in further detail.

The data describing the design of the spectacle frame 300 is retrieved from one or more spectacle frame design data storage modules number 140.1 through 140.n. Data is retrieved by instruction of an operator of the computer 100, for example per instructions of the intended wearer of the spectacle frame 300. Various design houses may provide various designs for various spectacle frames. The spectacle design data may be stored in one large data warehouse. Alternatively, each design house has its own repository for storing spectacle design data related to various designs for various spectacle frames. Each design house may provide an overview of the various designs, either in a paper catalogue or an electronic catalogue, either on-line or off-line. An advantage of an electronic catalogue is that data may be retrieved in one go, with a link between the catalogue and one or more of the spectacle frame design data storage modules 140.n.

In step 408, the biometric data is tested with the spectacle frame design data by a specification data check sub-unit 116 of the processing unit 110. It may be that the head 200 of the intended wearer of the spectacle frame 300 is too high, too wide, too narrow for the spectacle frame 300 or has otherwise dimensions that are incompatible with the spectacle frame 300. This may be the case, even though, as discussed before, the spectacle design data may be adapted to fit to the head 200 of the user by providing biometric data. This because there may be certain limits to which extent such adaptation is possible. It may be that if certain variables of a mathematical system describing the spectacle frame 300 would go beyond such limits, the design of the spectacle frame 300 would be malformed. The malformation may be considered from an esthetical point of view, as well as from a functional or ergonomic point of view.

If the formation of the spectacle frame 300 would be such that there is no question of malformation, so if the biometric input data is within certain pre-determined ranges, the biometric data is applied to the data describing the spectacle frame 300 in step 410. As discussed before, the data of the spectacle frame 300 is preferably provided as a mathematical model, where a system of splines is preferred in particular. Within the domain of splines, NURBS or non-uniform rational B splines are preferred in particular.

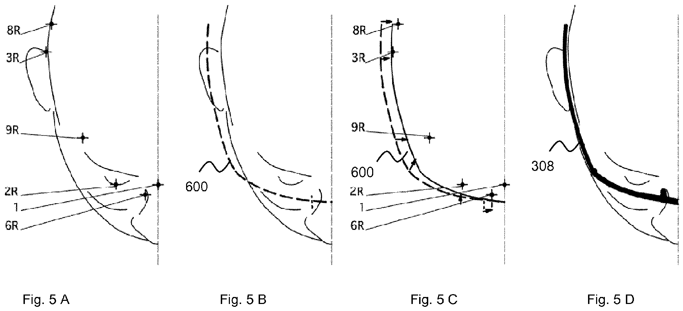

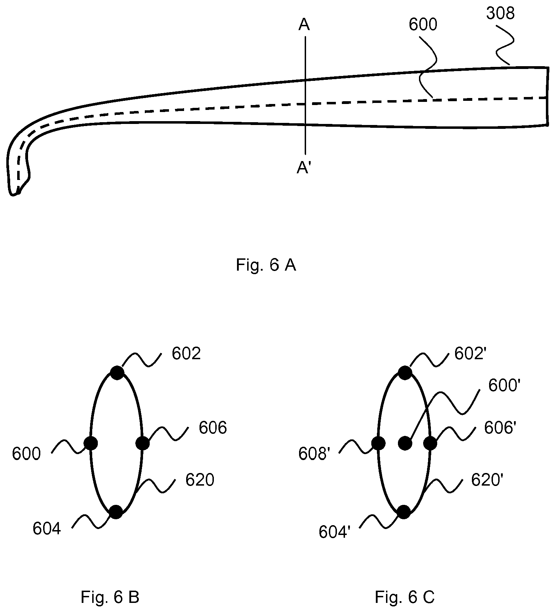

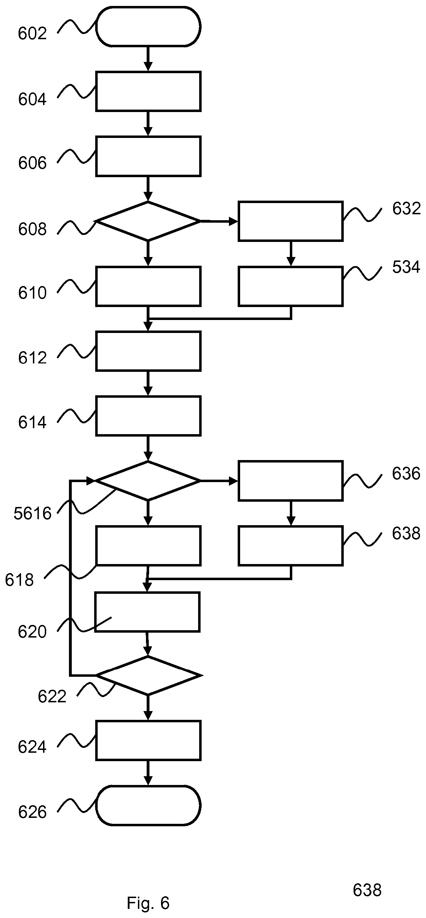

Application of the biometric data to the spectacle design data as performed in step 410 will be discussed in further detail in conjunction with Figure 5 A, Figure 5 B, Figure 5 C and Figure 5 D, as well as with Figure 6 A, Figure 6 B and Figure 6 C. Figure 5 A, Figure 5 B, Figure 5 C and Figure 5 D indicate how in step 410 the biometric design data is applied to the spectacle frame design and to the design of the right arm 308 in particular. Figure 6 A shows the right arm 308 with a main right arm spline 600 defining a main curvature of the right arm 308. Figure 6 B and Figure 6 C show a cross-section of the right arm 308 with the main spline and various auxiliary splines defining a shape of the right arm 308.

Figure 5 A indicates relevant biometric data as reference points as discussed before. Figure 5 B shows schematically how the spectacle frame 300 as defined by the spectacle frame data that has been retrieved from the design house fits around the head 200. As discussed before, the design data is preferably provided as a combination of splines and NURBS in particular. The design comprises main splines for defining the basic shapes of the various elements of the spectacle frame, like the curvature of the upper rims, the lower rims and the arms (also known as temples). This is elucidated by Figure 6 A, showing the right arm 308. In the middle of the right arm 308, a main right arm spline 600 is defined. The main right arm spline 600 defines the curvature of the right arm 308. The further shape of the right arm, like thickness and width, may be defined by further auxiliary splines. Such auxiliary splines may be defined as lines, surfaces or as a combination thereof. In the latter case, some splines may be lines and some may be surfaces.

This is further depicted in Figure 6 B. Figure 6 B shows a cross-section of the right arm 308 through the line A - A' as depicted by Figure 6 A. Figure 6 B shows the main spline 600, a first auxiliary spline 602, a second auxiliary spline 604 and a third auxiliary spline 606. The auxiliary splines are defined as being dependent on the definition of the main right arm spline 600. The curvature of a right arm surface 620 of the right arm 308 is defined by providing a smoothened surface connecting the main right arm spline 600 and the auxiliary splines. Such surface may be provided in any way around the main and auxiliary splines available. The degree of smoothness is preferably two or higher, in order to prevent sharp edges at the location of main and auxiliary splines.

Alternatively, auxiliary splines are defined around a main spline. In this case, a surface is provided connecting the auxiliary splines, rather than connecting the auxiliary splines and the main spline. This is depicted by Figure 6 C, showing a main right arm spline 600' and a first auxiliary spline 602', a second auxiliary spline 604', a third auxiliary spline 606' and a fourth auxiliary spline 608. A surface 620' of the right arm 308 is provided as a smoothened surface connecting the auxiliary splines.

In yet another alternative, the surface of the right arm 308 is defined as a spline itself. It may be defined as an independently defined spline or as an auxiliary spline dependent on the main right arm spline defined either as a line, as discussed before, or as a surface.

Figure 5 B shows the main right arm spline 600 of the right arm 308 provided around the head 200, with biometric data not applied, yet. The main right arm spline 600 is provided at a relatively large distance from the head 200. This means that the right arm 308 as defined by the spectacle design data as received from design house does not properly fit the head 200. By applying the biometric data received in step 404 to the spectacle frame design data received in step 406, parameters of the main right arm spline 600 are modified by providing coordinates of the reference points on the head 200. The reference points around the head 200 may serve as control points to the main right arm spline 600. With this input, and/or further modification of the mathematical model describing the main right arm spline 600, the main right arm spline 600 may be modified to have the shape of the right arm 308 defined by the main right arm spline 600 fit around the head 200 . Additionally or alternatively, also the values of the control vector of the main right arm spline 600 are modified by applying the biometric data.

This is depicted by Figure 5 C, which indicates at which points the main right arm spline 600 is controlled by the reference points. Figure 5 D shows the main right arm spline 600 adapted to the control points defined by the reference points on the head and with the right arm surface 620 defined and rendered. This results in a user specific spectacle design. The calculation of the shape of the main spline 600 and the auxiliary splines based on the reference points as input is performed by a curve calculation sub-unit 112 of the processing unit 110. The calculation of the surface 620 and a volume contained by it is performed by a volume rendering sub-unit 114 of the processing unit 110.

As discussed above, it may be possible that a mathematical model describing the spectacle frame 300 cannot be fully adapted to have the spectacle frame 300 adapted to the head 200. In that case, the procedure branches from step 408 to step 432. In step 432, variables of the mathematical model describing the spectacle frame 300 and affected by the reference points of the face 200 are set to an upper or lower limit defined in the model, whichever is closest to the input parameter. Subsequently, an error message is issued informing a user of the computer 100 that the spectacle frame 300 may not be properly fit to the head 200. After generation of the warning, the procedure continues to step 412. Alternatively, the procedure ends or asks for input by specifying another spectacle frame design to start from.

The user specific spectacle frame 300 thus provided by recalculating a mathematical model modified with biometric data as input is shown on the display 130 in step 412. Subsequently, in step 414, user input may be received for further adaptation of the user specific spectacle frame 300. Such user input may be provided by means of the keyboard 122, the mouse 124, other, or a combination thereof. Although the intention of having the mathematical model describing the spectacle frame 300 is to provide a spectacle frame that fully fits to the head 200, it may be that the intended wearer has certain preferences in addition or as an alternative. In a preferred embodiment, a user can select points on the spectacle frame 300 shown on the display 130 by means of the mouse 124 and/or the touch screen provided by the display 130 for shaping certain elements of the spectacle frame in a preferred way.

The input from the intended wearer of the spectacle frame 300 - or another person - is handled similarly as the biometric data provided in this embodiment as the reference points depicted by Figure 2. In step 416, the specification data check sub-unit 416 of the processing unit 110 checks whether the desired modifications of the user specific spectacle frame 300 comply with specifications of the spectacle frame design as provided in the mathematical model received from a design house. If that is the case, the modifications as desired are applied to the user specific spectacle frame 300 and to the mathematical model describing the user specific spectacle frame 300 in particular in step 418. This results in a bespoke spectacle frame. In step 420, the bespoke spectacle frame is shown to the intended wearer of the spectacle frame 300 by means of the display 130.

In case the desired modifications of the user specific spectacle frame 300 do not comply with specifications of the spectacle frame design, for example because they exceed a certain limit, the procedure branches in step 418 to step 436, in which the upper limit is applied to the design data for the user specific spectacle frame 300. Analogously, if user input would result in a parameter to be lower than a lower threshold, the value of the lower threshold would be applied in step 436. Subsequently, an error message is generated and provided to the user in step 438. Such warning message may comprise a message that a user is to provide input again. The procedure continues to step 420 in which the spectacle frame with the extreme values - the limits as discussed - is shown to the intended wearer of the spectacle frame 300.

Having shown the bespoke spectacle frame, the procedure checks in step 422 whether there is additional input available for further modification of the mathematical model describing the design of the spectacle frame 300. If that is the case, the process branches back to step 416. If no further preference data is received, the procedure continues to step 424 by sending, via the network communication module 106, the design data to a three-dimensional printer 160 for printing the spectacle frame 300. This step may be preceded by an explicit confirmation step. The data sent to the printer may be the mathematical model describing the various splines that form the design of the spectacle frame 300 and that have been modified in accordance with input parameters received. Alternatively, the actual shape of the spectacle frame 300 is rendered by the volume rendering sub-unit 114 of the processing unit 110.

The data being the outcome of this rendering step may subsequently be sent to the three-dimensional printer 160. Alternatively, other methods may be employed to cast the design of the user specific spectacle frame 300 in a physical product, for example by manufacturing a mould based on the spectacle frame design data modified by input of the biometric data and the user preference data.

Expressions such as "comprise", "include", "incorporate", "contain", "is" and "have" are to be construed in a non-exclusive manner when interpreting the description and its associated claims, namely construed to allow for other items or components which are not explicitly defined also to be present. Reference to the singular is also to be construed in be a reference to the plural and vice versa. When data is being referred to as audiovisual data, it can represent audio only, video only or still pictures only or a combination thereof, unless specifically indicated otherwise in the description of the embodiments.

In the description above, it will be understood that when an element such as layer, region or substrate is referred to as being "on", "onto" or "connected to" another element, the element is either directly on or connected to the other element, or intervening elements may also be present.

Furthermore, the invention may also be embodied with less components than provided in the embodiments described here, wherein one component carries out multiple functions. Just as well may the invention be embodied using more elements than depicted in the Figures, wherein functions carried out by one component in the embodiment provided are distributed over multiple components.

It is stipulated that the reference signs in the claims do not limit the scope of the claims, but are merely inserted to enhance the legibility of the claims.

This application claims reference of patent application NL 2010009.

## Claims

1. A computer implemented method of determining user preferred dimensions of a spectacle frame for providing a bespoke spectacle frame design, the method comprising:
- Receiving locations of reference points on or around a head of an intended wearer of the spectacle frame as biometric data related to dimensions of a head of the user;
- Receiving pre-determined design data on a spectacle frame comprising a mathematical system describing the spectacle frame, the system comprising a first mathematical model describing a main curve defining a shape of an element of the spectacle, the mathematical model comprising at least one variable that can be adapted based on the biometrics data and/or user preference data, wherein the pre-determined design data further comprises a second mathematical model describing a first support curve and a third mathematical model describing a second support curve, the main curve, the first support curve and the second support curve defining a volume of the spectacle frame, wherein the second mathematical model and the third mathematical model are dependent on the first mathematical model, and wherein the mathematical models each comprise splines;
- Applying the biometrics data to the pre-determined design data by applying the locations of the reference points as control points for the splines, yielding a user specific spectacle frame design;
- Providing the user specific frame design to the user;
- Receiving the user preference data related to the user specific frame design;
- Applying the user preference data to the user specific design, yielding the bespoke spectacle frame design defined by bespoke spectacle frame design data;
- Providing the bespoke spectacle frame design to the user; and
- Sending the bespoke spectacle frame design to a three-dimensional printer for printing the spectacle frame.

2. Method according to claim 1, wherein:
- the pre-determined design data comprises a first pre-determined spectacle frame biometric value defining a first spectacle frame dimension of a first element of the spectacle frame;
- The biometric data comprises a first biometric value related to the first spectacle frame dimension; and
- Applying the biometrics data to the pre-determined design data comprises adapting the first pre-determined spectacle frame biometric value to adapt the spectacle frame to the first biometric value.

3. Method according to claim 1 or 2, wherein:
- The pre-determined design data comprises a first pre-determined spectacle frame preference value defining a second spectacle frame dimension of a second element of the spectacle frame;
- The user preference data comprises a first preference value related to the second spectacle frame dimension; and
- Applying the user preference data to the user specific design comprises adapting the first pre-determined spectacle frame preference value to adapt the user specific design to the first user preference value.

4. Method according to claim 2, the pre-determined design data comprising a data range indicating a maximum value and a minimum value of the spectacle frame biometric value defining a first spectacle frame dimension, the method further comprising:
- Setting the first pre-determined spectacle frame biometric value to the minimum value if the first pre-determined spectacle frame biometric value would be lower than the minimum value to adapt the spectacle frame to the first biometric value; and
- Setting the first pre-determined spectacle frame biometric value to the maximum value if the first spectacle frame biometric value would be higher than the maximum value to adapt the spectacle frame to the first biometric value.

5. Method according to claim 3, the pre-determined design data comprising a data range indicating a maximum value and a minimum value of the spectacle frame preference value defining a second spectacle frame dimension, the method further comprising:
- Setting the first pre-determined spectacle frame preference value to the minimum value if the first pre-determined spectacle frame preference value would be lower than the minimum value to adapt the spectacle frame to the first preference value; and
- Setting the first pre-determined spectacle frame preference value to the maximum value if the first pre-determined spectacle frame preference value would be higher than the minimum value to adapt the spectacle frame to the first preference value.

6. Method according to any of the preceding claims, wherein the user preference data comprises data related to at least one of the following:
- Curvature of a front part of the spectacle frame in a horizontal plane;
- Curvature of a front part of the spectacle frame in a vertical plane;
- Curvature of the drop of the arm relative to the part of the arm connected to the front.

7. Device for determining user preferred dimensions of a spectacle frame for providing a bespoke spectacle frame design, the device comprising:
- A data input module arranged to:
- Receive locations of reference points on or around a head of an intended wearer of the spectacle frame as biometric data related to dimensions of a head of the user;
- Receive pre-determined design data on a spectacle frame comprising a mathematical system describing the spectacle frame, the system comprising a first mathematical model describing a main curve defining a shape of an element of the spectacle, the mathematical model comprising at least one variable that can be adapted based on the biometrics data and/or user preference data, wherein the pre-determined design data further comprises a second mathematical model describing a first support curve and a third mathematical model describing a second support curve, the main curve, the first support curve and the second support curve defining a volume of the spectacle frame, wherein the second mathematical model and the third mathematical model are dependent on the first mathematical model, and wherein the mathematical models each comprise splines;
- Receiving user preference data related to the user specific frame design;
- A processing unit arranged to:
- Apply the biometrics data to the pre-determined design data by applying the locations of the reference points as control points for the splines, yielding a user specific spectacle frame design;
- Apply the user preference data to the user specific design, yielding the bespoke spectacle frame design defined by bespoke spectacle frame design data; and
- Send the bespoke spectacle frame design to a three-dimensional printer for printing the spectacle frame.

8. Computer programme product comprising code executable by a computer, enabling the computer to execute the method according to any of the claims 1 to 6.

## Patentansprüche

1. Computerimplementiertes Verfahren zur Bestimmung benutzerbevorzugter Abmaße einer Brillenfassung zur Bereitstellung eines maßgeschneiderten Brillenfassungsdesigns, wobei das Verfahren umfasst:
- Empfangen von Positionen von Referenzpunkten auf oder um einem Kopf eines beabsichtigten Trägers der Brillenfassung als biometrische Daten in Bezug auf Abmessungen eines Kopfes des Benutzers;
- Empfangen vorbestimmter Designdaten für eine Brillenfassung, umfassend ein die Brillenfassung beschreibendes mathematisches System, wobei das System ein erstes mathematisches Modell umfasst, das eine Hauptkurve beschreibt, die eine Form eines Elements der Brille definiert, wobei das mathematische Modell mindestens eine Variable umfasst, die basierend auf den biometrischen Daten und/oder Benutzerpräferenzdaten angepasst werden kann, wobei die vorbestimmten Designdaten ferner ein zweites mathematisches Modell umfassen, das eine erste Stützkurve beschreibt, sowie ein drittes mathematisches Modell, das eine zweite Stützkurve beschreibt, wobei die Hauptkurve, die erste Stützkurve und die zweite Stützkurve ein Volumen der Brillenfassung definieren, wobei das zweite mathematische Modell und das dritte mathematische Modell vom ersten mathematischen Modell abhängig sind, und wobei die mathematischen Modelle jeweils Splines umfassen;
- Anwenden der biometrischen Daten auf die vorbestimmten Designdaten durch Verwenden der Positionen der Referenzpunkte als Kontrollpunkte für die Splines, was zu einem benutzerspezifischen Brillenfassungsdesign führt;
- Bereitstellen des benutzerspezifischen Fassungsdesigns für den Benutzer;
- Empfangen der Benutzerpräferenzdaten in Bezug auf das benutzerspezifische Fassungsdesign;
- Anwenden der Benutzerpräferenzdaten auf das benutzerspezifische Design, um das maßgeschneiderte Brillenfassungsdesign zu erhalten, das durch maßgeschneiderte Brillenfassungsdesigndaten definiert ist;
- Bereitstellen des maßgeschneiderten Brillenfassungsdesigns für den Benutzer; und
- Senden des maßgeschneiderten Brillenfassungsdesigns an einen 3D-Drucker zum Drucken der Brillenfassung.

2. Verfahren nach Anspruch 1, wobei:
- die vorbestimmten Designdaten einen ersten vorbestimmten biometrischen Wert der Brillenfassung, der eine erste Brillenfassungsabmessung eines ersten Elements der Brillenfassung definiert, umfassen;
- die biometrischen Daten einen ersten biometrischen Wert in Bezug auf die erste Brillenfassungsabmessung umfassen; und
- das Anwenden der biometrischen Daten auf die vorbestimmten Designdaten das Anpassen des ersten vorbestimmten biometrischen Brillenfassungswerts umfasst, um die Brillenfassung an den ersten biometrischen Wert anzupassen.

3. Verfahren nach Anspruch 1 oder 2, wobei:
- die vorbestimmten Designdaten einen ersten vorbestimmten Brillenfassungspräferenzwert, der eine zweite Brillenfassungsabmessung eines zweiten Elements der Brillenfassung definiert, umfassen;
- die Benutzerpräferenzdaten einen ersten Präferenzwert in Bezug auf die zweite Brillenfassungsabmessung umfassen; und
- das Anwenden der Benutzerpräferenzdaten auf das benutzerspezifische Design das Anpassen des ersten vorbestimmten Brillenfassungspräferenzwerts umfasst, um das benutzerspezifische Design an den ersten Benutzerpräferenzwert anzupassen.

4. Verfahren nach Anspruch 2, wobei die vorbestimmten Designdaten einen Datenbereich umfassen, der einen Maximalwert und einen Minimalwert des biometrischen Werts der Brillenfassung angibt, der eine erste Brillenfassungsabmessung definiert, wobei das Verfahren ferner umfasst:
- Setzen des ersten vorbestimmten biometrischen Werts der Brillenfassung auf den Minimalwert, falls der erste vorbestimmte biometrische Wert der Brillenfassung niedriger als der Minimalwert ist, um die Brillenfassung an den ersten biometrischen Wert anzupassen; und
- Setzen des ersten vorbestimmten biometrischen Werts der Brillenfassung auf den Maximalwert, falls der erste biometrische Wert der Brillenfassung höher als der Maximalwert ist, um die Brillenfassung an den ersten biometrischen Wert anzupassen.

5. Verfahren nach Anspruch 3, wobei die vorbestimmten Designdaten einen Datenbereich umfassen, der einen Maximalwert und einen Minimalwert des Brillenfassungspräferenzwerts angibt, der eine zweite Brillenfassungsabmessung definiert, wobei das Verfahren ferner umfasst:
- Setzen des ersten vorbestimmten Brillenfassungspräferenzwerts auf den Minimalwert, falls der erste vorbestimmte Brillenfassungspräferenzwert niedriger als der Minimalwert ist, um die Brillenfassung an den ersten Präferenzwert anzupassen; und
- Setzen des ersten vorbestimmten Brillenfassungspräferenzwerts auf den Maximalwert, falls der erste vorbestimmte Präferenzwert der Brillenfassung höher als der Minimalwert ist, um die Brillenfassung an den ersten Präferenzwert anzupassen.

6. Verfahren nach einem der vorhergehenden Ansprüche, wobei die Benutzerpräferenzdaten Daten umfassen, die sich auf mindestens eine der folgenden beziehen:
- Krümmung eines vorderen Teils der Brillenfassung in einer horizontalen Ebene;
- Krümmung eines vorderen Teils der Brillenfassung in einer vertikalen Ebene;
- Krümmung des Absinkens des Bügels im Verhältnis zu dem Teil des Bügels, der mit der Vorderseite verbunden ist.

7. Einrichtung zur Bestimmung benutzerbevorzugter Abmaße einer Brillenfassung zur Bereitstellung eines maßgeschneiderten Brillenfassungsdesigns, wobei die Einrichtung umfasst:
- ein Dateneingabemodul, angeordnet zum:
- Empfangen von Positionen von Referenzpunkten auf oder um einen Kopf eines beabsichtigten Trägers der Brillenfassung als biometrische Daten in Bezug auf Abmessungen eines Kopfes des Benutzers;
- Empfangen vorbestimmter Designdaten zu einer Brillenfassung, umfassend ein mathematisches System, das die Brillenfassung beschreibt, wobei das System ein erstes mathematisches Modell umfasst, das eine Hauptkurve beschreibt, die eine Form eines Elements der Brille definiert, wobei das mathematische Modell mindestens eine Variable umfasst, die basierend auf den biometrischen Daten und/oder Benutzerpräferenzdaten angepasst werden kann, wobei die vorbestimmten Designdaten ferner ein zweites mathematisches Modell umfassen, das eine erste Stützkurve beschreibt, und ein drittes mathematisches Modell, das eine zweite Stützkurve beschreibt, wobei die Hauptkurve, die erste Stützkurve und die zweite Stützkurve ein Volumen der Brillenfassung definieren, wobei das zweite mathematische Modell und das dritte mathematische Modell vom ersten mathematischen Modell abhängig sind, und wobei die mathematischen Modelle jeweils Splines umfassen;
- Empfangen von Benutzerpräferenzdaten in Bezug auf das benutzerspezifische Fassungsdesign;
- eine Verarbeitungseinheit, angeordnet zum:
- Anwenden der biometrischen Daten auf die vorbestimmten Designdaten, indem die Positionen der Referenzpunkte als Kontrollpunkte für die Splines verwendet werden, wodurch ein benutzerspezifisches Brillenfassungsdesign entsteht;
- Anwenden der Benutzerpräferenzdaten auf das benutzerspezifische Design, wodurch das maßgeschneiderte Brillenfassungsdesign, definiert durch maßgeschneiderte Brillenfassungsdesigndaten, entsteht; und
- Senden des maßgeschneiderten Brillenfassungsdesigns an einen 3D-Drucker zum Drucken der Brillenfassung.

8. Computerprogrammprodukt, umfassend von einem Computer ausführbaren Code, das es dem Computer ermöglicht, das Verfahren nach einem der Ansprüche 1 bis 6 auszuführen.

## Revendications

1. Procédé mis en œuvre par ordinateur de détermination de dimensions préférées d'un utilisateur d'une monture de lunettes pour la fourniture d'une conception de monture de lunettes sur mesure, le procédé comprenant :
- la réception d'emplacements de points de référence sur ou autour d'une tête d'un porteur envisagé de la monture de lunettes sous la forme de données biométriques relatives aux dimensions d'une tête de l'utilisateur ;
- la réception de données de conception prédéterminées sur une monture de lunettes comprenant un système mathématique décrivant la monture de lunettes, le système comprenant un premier modèle mathématique décrivant une courbe principale définissant une forme d'un élément des lunettes, le modèle mathématique comprenant au moins une variable qui peut être adaptée sur la base des données biométriques et/ou de données de préférence d'utilisateur, dans lequel les données de conception prédéterminées comprennent en outre un deuxième modèle mathématique décrivant une première courbe de support et un troisième modèle mathématique décrivant une deuxième courbe de support, la courbe principale, la première courbe de support et la deuxième courbe de support définissant un volume de la monture de lunettes, dans lequel le deuxième modèle mathématique et le troisième modèle mathématique sont dépendants du premier modèle mathématique, et dans lequel les modèles mathématiques comprennent chacun des splines ;
- l'application des données biométriques aux données de conception prédéterminées par l'application des emplacements des points de référence en tant que points de contrôle pour les splines, ce qui aboutit à une conception de monture de lunettes spécifique à un utilisateur ;
- la fourniture de la conception de monture spécifique à un utilisateur à l'utilisateur ;
- la réception des données de préférence d'utilisateur relatives à la conception de monture spécifique à un utilisateur ;
- l'application des données de préférence d'utilisateur à la conception spécifique à un utilisateur, ce qui aboutit à la conception de monture de lunettes sur mesure définie par des données de conception de monture de lunettes sur mesure ;
- la fourniture de la conception de monture de lunettes sur mesure à l'utilisateur ; et
- l'envoi de la conception de monture de lunettes sur mesure à une imprimante en trois dimensions pour l'impression de la monture de lunettes.

2. Procédé selon la revendication 1, dans lequel :
- les données de conception prédéterminées comprennent une première valeur biométrique de monture de lunettes prédéterminée définissant une première dimension de monture de lunettes d'un premier élément de la monture de lunettes ;
- les données biométriques comprennent une première valeur biométrique relative à la première dimension de monture de lunettes ; et
- l'application des données biométriques aux données de conception prédéterminées comprend l'adaptation de la première valeur biométrique de monture de lunettes prédéterminée pour adapter la monture de lunettes à la première valeur biométrique.

3. Procédé selon la revendication 1 ou 2, dans lequel :
- les données de conception prédéterminées comprennent une première valeur de préférence de monture de lunettes prédéterminée définissant une deuxième dimension de monture de lunettes d'un deuxième élément de la monture de lunettes ;
- les données de préférence d'utilisateur comprennent une première valeur de préférence relative à la deuxième dimension de monture de lunettes ; et
- l'application des données de préférence d'utilisateur à la conception spécifique à un utilisateur comprend l'adaptation de la première valeur de préférence de monture de lunettes prédéterminée pour adapter la conception spécifique à un utilisateur à la première valeur de préférence d'utilisateur.

4. Procédé selon la revendication 2, les données de conception prédéterminées comprenant une plage de données indiquant une valeur maximale et une valeur minimale de la valeur biométrique de monture de lunettes définissant une première dimension de monture de lunettes, le procédé comprenant en outre :
- le réglage de la première valeur biométrique de monture de lunettes prédéterminée sur la valeur minimale si la première valeur biométrique de monture de lunettes prédéterminée était inférieure à la valeur minimale pour adapter la monture de lunettes à la première valeur biométrique ; et
- le réglage de la première valeur biométrique de monture de lunettes prédéterminée sur la valeur maximale si la première valeur biométrique de monture de lunettes était supérieure à la valeur maximale pour adapter la monture de lunettes à la première valeur biométrique.

5. Procédé selon la revendication 3, les données de conception prédéterminées comprenant une plage de données indiquant une valeur maximale et une valeur minimale de la valeur de préférence de monture de lunettes définissant une deuxième dimension de monture de lunettes, le procédé comprenant en outre :
- le réglage de la première valeur de préférence de monture de lunettes prédéterminée sur la valeur minimale si la première valeur de préférence de monture de lunettes prédéterminée était inférieure à la valeur minimale pour adapter la monture de lunettes à la première valeur de préférence ; et
- le réglage de la première valeur de préférence de monture de lunettes prédéterminée sur la valeur maximale si la première valeur de préférence de monture de lunettes prédéterminée était supérieure à la valeur minimale pour adapter la monture de lunettes à la première valeur de préférence.

6. Procédé selon l'une quelconque des revendications précédentes, dans lequel les données de préférence d'utilisateur comprennent des données relatives à au moins l'une parmi ce qui suit :
- la courbure d'une partie avant de la monture de lunettes dans un plan horizontal ;
- la courbure d'une partie avant de la monture de lunettes dans un plan vertical ;
- la courbure de la baisse de la branche par rapport à la partie de la branche reliée à l'avant.

7. Dispositif pour la détermination de dimensions préférées d'un utilisateur d'une monture de lunettes pour la fourniture d'une conception de monture de lunettes sur mesure, le dispositif comprenant :
- un module d'entrée de données conçu pour :
- recevoir des emplacements de points de référence sur ou autour d'une tête d'un porteur envisagé de la monture de lunettes sous la forme de données biométriques relatives aux dimensions d'une tête de l'utilisateur ;
- recevoir des données de conception prédéterminées sur une monture de lunettes comprenant un système mathématique décrivant la monture de lunettes, le système comprenant un premier modèle mathématique décrivant une courbe principale définissant une forme d'un élément des lunettes, le modèle mathématique comprenant au moins une variable qui peut être adaptée sur la base des données biométriques et/ou de données de préférence d'utilisateur, dans lequel les données de conception prédéterminées comprennent en outre un deuxième modèle mathématique décrivant une première courbe de support et un troisième modèle mathématique décrivant une deuxième courbe de support, la courbe principale, la première courbe de support et la deuxième courbe de support définissant un volume de la monture de lunettes, dans lequel le deuxième modèle mathématique et le troisième modèle mathématique sont dépendants du premier modèle mathématique, et dans lequel les modèles mathématiques comprennent chacun des splines ;
- recevoir des données de préférence d'utilisateur relatives à la conception de monture spécifique à un utilisateur ;
- une unité de traitement conçue pour :
- appliquer les données biométriques aux données de conception prédéterminées par l'application des emplacements des points de référence en tant que points de contrôle pour les splines, ce qui aboutit à une conception de monture de lunettes spécifique à un utilisateur ;
- appliquer les données de préférence d'utilisateur à la conception spécifique à un utilisateur, ce qui aboutit à la conception de monture de lunettes sur mesure définie par des données de conception de monture de lunettes sur mesure ; et
- envoyer la conception de monture de lunettes sur mesure à une imprimante en trois dimensions pour l'impression de la monture de lunettes.

8. Produit programme d'ordinateur comprenant un code exécutable par un ordinateur, permettant à l'ordinateur d'exécuter le procédé selon l'une quelconque des revendications 1 à 6.
